# EUROPEAN PATENT SPECIFICATION

(11) **EP 2 607 448 B1**
(45) Date of publication and mention of the grant of the patent: **02.04.2014**
(21) Application number: 12198260.7
(22) Date of filing: 19.12.2012
(51) Int. Cl.: C09K 11/77, H05B 33/12, H01L 33/50

(54) **Yttrium-Cerium-Aluminum garnet phosphor and light-emitting device**
Yttrium-Cer-Aluminium-Granatphosphor und lichtemittierende Diode
Phosphore grenat dopé à l'yttrium-cerium-aluminum et dispositif électroluminescent

(30) Priority: 22.12.2011 JP 2011281416
(43) Date of publication of application: 26.06.2013
(73) Proprietor: Shin-Etsu Chemical Co., Ltd., Chiyoda-ku, Tokyo (JP)
(72) Inventor: WATAYA, Kazuhiro, Echizen-shi,, Fukui (JP); TSUKATANI, Toshihiko, Echizen-shi, Fukui (JP); KAWAZOE, Hirofumi, Echizen-shi, Fukui (JP); MINOWA, Takehisa, Echizen-shi, Fukui (JP)
(74) Representative: Stoner, Gerard Patrick

(56) References cited:
- EP-A1- 0 936 682
- WO-A1-2011/063028
- WO-A1-2011/097137
- WO-A2-2009/102727
- KR-A- 20080 075 972

## Description

### TECHNICAL FIELD

This invention relates to a yttrium-cerium-aluminum garnet (sometimes referred to as YAG:Ce) phosphor for converting the wavelength of light from a light-emitting element, and a light-emitting device comprising the YAG:Ce phosphor. More particularly, it relates to a particulate YAG:Ce phosphor suited for constructing white light-emitting devices which are used to construct illuminating devices including general illuminating devices, backlight devices and headlamp devices.

### BACKGROUND

Light-emitting diodes (LEDs) are the most efficient among currently available light sources. In particular, white LEDs find a rapidly expanding share in the market as the next-generation light source to replace incandescent lamps, fluorescent lamps, cold cathode fluorescent lamps (CCFL), and halogen lamps. The white LEDs are arrived at by combining a blue LED with a phosphor capable of emission upon blue light excitation. Typically, green or yellow phosphors are combined with blue LEDs to produce pseudo-white light. Suitable phosphors include Y₃Al₅O₁₂: Ce, (Y, Gd)₃(Al, Ga)₅O₁₂ : Ce, (Y, Gd)₃Al₅O₁₂ : Ce, Tb₃Al₅O₁₂ : Ce, CaGa₂S₄:Eu, (Sr, Ca, Ba)₂SiO₄ : Eu, and Ca-α-SiAlON:Eu.

Among these, the Y₃Al₅O₁₂:Ce phosphor is most often used because it has a high emission efficiency upon blue light excitation. It is prepared, as disclosed in JP 3700502, for example, by dissolving rare earth elements Y and Ce in a proper stoichiometric ratio in an acid, coprecipitating the solution with oxalic acid, firing the coprecipitate into coprecipitate oxide, mixing it with aluminum oxide, and adding a fluoride (e.g., ammonium fluoride or barium fluoride) as flux thereto. The mixture is placed in a crucible and fired in air at 1,400°C for 3 hours. The fired material is wet milled in a ball mill, washed, separated, dried, and finally sieved.

For the typical example of Y₃Al₅O₁₂:Ce phosphor, it is described that its emission color can be shifted to the longer wavelength side by substituting gadolinium for part of yttrium. Undesirably, this substitution is at the sacrifice of the quantum efficiency of emission at room temperature and the emission performance at high temperature.

### Citation List

Patent Document 1: JP 3700502

### THE INVENTION

An object of the invention is to provide new yttrium-cerium-aluminum garnet (YAG:Ce) phosphors which enable emission color to be shifted to the longer wavelength side without needing to substitute gadolinium for part of yttrium and without sacrificing the emission performance at high temperature.

Regarding a yttrium-cerium-aluminum garnet phosphor consisting of crystalline grains as matrix phase, the inventors have found that if nanocrystalline grains having an average grain size of 5 to 20 nm and containing cerium in a higher concentration than the average cerium concentration of the matrix phase are dispersed in the crystalline grains, the phosphor is capable of producing emission color having a x value of 0.47 to 0.54 on the xy chromaticity coordinates when excited with 450 nm light. Also, the peak intensity of emission spectrum at a phosphor temperature of 80°C is at least 93% of the peak intensity of emission spectrum at a phosphor temperature of 25°C. The invention is predicated on these findings.

In one aspect, the invention provides a yttrium-cerium-aluminum garnet phosphor having a crystallographic texture wherein the crystallographic texture is based on a matrix phase, and nanocrystalline grains having a grain size of 5 to 20 nm and containing cerium in a higher concentration than the cerium concentration of the matrix phase are dispersed in the crystallographic texture.

Typically, the phosphor produces emission color having a x value of 0.47 to 0.54 on the xy chromaticity coordinates when excited with 450 nm light.

Preferably, cerium is present in a concentration of 4 mol% to 15 mol% based on the sum of yttrium and cerium. Also preferably, the cerium concentration of the nanocrystalline grains is 1 to 20% by weight higher than the cerium concentration of the matrix phase.

In a preferred embodiment, the phosphor produces an emission spectrum when excited with 450 nm light, wherein the peak intensity of emission spectrum at a phosphor temperature of 80°C is at least 93% of the peak intensity of emission spectrum at a phosphor temperature of 25°C.

In another aspect, the invention provides a light-emitting device comprising a light-emitting element for emitting light having a wavelength of 400 to 470 nm and the phosphor, defined above, for converting the wavelength of at least part of light from the light-emitting element.

Methods of preparation and use of the present phosphors are further aspects herein.

### ADVANTAGEOUS EFFECTS

In the YAG:Ce phosphor of the invention, nanocrystalline grains having a size of 5 to 20 nm and containing cerium in a higher concentration than the cerium concentration of the matrix phase are dispersed in the crystallographic texture. The emission color of the phosphor can be shifted to the longer wavelength side than in the prior art phosphors. Since elements other than Y, Ce, and Al can then be excluded as main components, phosphors are then available which maintain satisfactory emission (or fluorescent) performance even at high temperature.

### BRIEF DESCRIPTION OF DRAWINGS

FIG. 1 is a diagram showing chromaticity x versus cerium concentration of YAG:Ce phosphors.
FIG. 2 is a TEM image showing the crystallographic texture of YAG:Ce phosphor in Example 1, FIG. 2(a) being a micrograph of a portion of the phosphor and FIG. 2(b) being an enlarged micrograph of a crystalline grain.
FIG. 3 is a TEM image of the crystallographic texture of YAG:Ce phosphor in Example 1, showing position (1) of TEM-EDX analysis.
FIG. 4 is a TEM image of the crystallographic texture of YAG:Ce phosphor in Example 1, showing position (2) of TEM-EDX analysis.
FIG. 5 is a TEM image of the crystallographic texture of YAG:Ce phosphor in Example 1, showing position (3) of TEM-EDX analysis.
FIG. 6 is a TEM image showing the crystallographic texture of YAG:Ce phosphor in Comparative Example 1, FIG. 6(a) being a micrograph of a portion of the phosphor and FIG. 6(b) being an enlarged micrograph of a crystalline grain.

### FURTHER EXPLANATIONS; OPTIONS AND PREFERENCES

As used herein, the term "phosphor" refers to a fluorescent substance. The terms "particles" and "powder" are equivalent in that the powder is a grouping of particles.

The yttrium-cerium-aluminum garnet phosphor (including those having part of yttrium substituted by gadolinium; referred to as YAG:Ce phosphor, hereinafter) is one of the phosphors most commonly used to construct white LED owing to its chemical stability, high quantum efficiency, and high emission efficiency attributable to a good match with human visual sensitivity. Many of white LEDs using YAG:Ce phosphor are known as pseudo-white LED. Most of these LEDs use blue LED in combination with YAG:Ce phosphor of yellow emission.

While a choice is made from a variety of pseudo-white LEDs whose emission color has different color temperatures depending on a particular application or purpose, means for changing the color temperature of LED is most often by changing the emission color of YAG:Ce phosphor. In turn, the means for changing the emission color of YAG:Ce phosphor is most often by substituting gadolinium for part of yttrium in YAG:Ce phosphor to change the chromaticity of its fluorescent spectrum.

Specifically, the YAG:Ce phosphor is such that x value on the xy chromaticity coordinates increases as the concentration of cerium or activator in the phosphor increases. However, the method of Patent Document 1 is difficult to incorporate cerium beyond a certain concentration because the ionic radius of cerium is greater than the ionic radius of yttrium (notably, ionic radius Y³⁺ = 0.893 Å, Ce³⁺ = 1.034 Å). For this reason, the common approach taken to produce YAG:Ce phosphor having a high x value is to substitute gadolinium for part of yttrium.

However, the high x-value YAG:Ce phosphor obtained by substituting gadolinium for part of yttrium has the tendency that as the degree of substitution of gadolinium increases, the emission efficiency of the phosphor near room temperature lowers and the emission intensity at high temperature remarkably drops. The lowering of the emission efficiency of the phosphor leads to a lowering of the emission efficiency of the white LED. The drop of the emission intensity at high temperature allows the color of light emitted by an LED illuminating device to change depending on the LED chip temperature or environment temperature. These properties are undesirable as the phosphor.

Making extensive investigations to improve a lowering of the emission performance at high temperature as found with the YAG:Ce phosphor having part of yttrium substituted by gadolinium while maintaining the shift of emission color to the longer wavelength side unchanged from that of the YAG:Ce phosphor having part of yttrium substituted by gadolinium, the inventors have arrived at the invention. The invention achieves this improvement by providing a YAG:Ce phosphor with the structure that nanocrystalline grains having an average grain size of 5 to 20 nm and containing cerium in a higher concentration than the cerium concentration of the matrix phase are dispersed in the crystallographic texture. The phosphor with this structure can achieve a chromaticity x value equivalent to that of the YAG:Ce phosphor having part of yttrium substituted by gadolinium, without incorporating gadolinium. Furthermore, we found that the present YAG:Ce phosphors exhibited excellent temperature performance in that when the emission peak intensity was measured by keeping it at temperatures of 25°C and 80°C and exciting with 450 nm light, the emission peak intensity at the phosphor temperature of 80°C was at least 93% of the emission peak intensity at the phosphor temperature of 25°C.

Now features of the presently-proposed YAG:Ce phosphors will be described and discussed in detail.

The inventors actually prepared YAG:Ce phosphors using the method of Patent Document 1. Gadolinium-free YAG:Ce phosphors, when excited with 450 nm light, were difficult to produce emission color with a x value of at least 0.47. To manufacture YAG:Ce phosphors capable of producing emission color with a x value of at least 0.47, it was necessary to substitute gadolinium for part of yttrium.

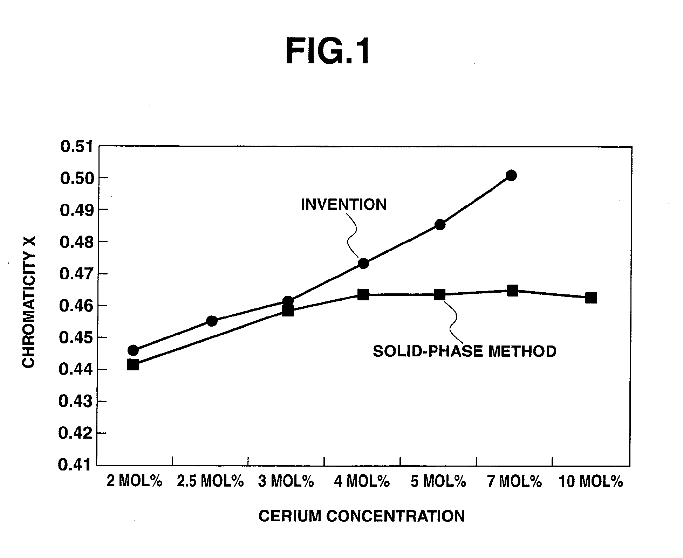

FIG. 1 shows a relationship of chromaticity versus cerium concentration of YAG:Ce phosphors. For those YAG:Ce phosphors prepared by the method of Patent Document 1 (depicted as solid-phase method in FIG. 1), the cerium concentration that is a percentage of charged cerium relative to entire charged rare earth elements (i.e., molar percentage of cerium relative to the sum of yttrium and cerium) is varied. In the range that the cerium concentration is less than 4 mol%, the x value increases as the cerium concentration increases. However, in the range that the cerium concentration exceeds 4 mol%, the x value no longer increases even when the cerium concentration increases. This probably indicates that cerium cannot be contained beyond 4 mol% in the finished YAG:Ce phosphors.

With the method of Patent Document 1, cerium as an activator cannot be incorporated beyond a certain concentration, because the method relies on a solid-phase reaction where YAG:Ce phosphor forms through a relatively slow crystal growth process. There is a strong tendency that cerium having a large ionic radius is expelled out of the crystallographic texture of YAG:Ce phosphor (or excreted out of the phosphor composition).

Then, the inventors attempted to produce YAG:Ce phosphors by rapidly melting and solidifying a YAG:Ce phosphor composition to form particles without affording a sufficient time for cerium to be excreted out of the phosphor composition, and causing crystal growth at high temperature. When the chromaticity of the resulting YAG:Ce phosphors was measured, the x value increased as the concentration of charged cerium in the raw material increased, as shown in FIG. 1. These YAG:Ce phosphors can contain cerium as activator in a high concentration, produce emission color with a x value of 0.47 to 0.54 when excited with 450 nm light, and eliminate a need to substitute gadolinium for part of yttrium.

The crystallographic texture of the YAG:Ce phosphor was analyzed under a transmission electron microscope (TEM), finding that nanocrystalline grains containing cerium in a higher concentration than the YAG:Ce crystalline matrix (referred to as "matrix phase," hereinafter) are dispersed in the crystallographic texture. As used herein, the term "nanocrystalline grains," also known as nanocrystals, refers to ultrafine crystal grains of nanometer order. The size of nanocrystalline grains is measured from TEM structural analysis, and given as a diameter of the minimum circle circumscribing a nanocrystalline grain under examination, for example.

The structure that nanocrystalline grains having a high cerium concentration are dispersed in the matrix phase was not observed in the YAG:Ce phosphors synthesized by the method of Patent Document 1. Also, even when YAG:Ce phosphors were synthesized by the same method as the invention, the distribution of nanocrystalline grains having a high cerium concentration in the matrix phase was not observed in those YAG:Ce phosphors wherein the concentration of charged cerium relative to the entire rare earth elements was 3 mol% or less. From these results, it was concluded that the distribution of nanocrystalline grains in the matrix phase is a characteristic structure obtained when a phosphor is synthesized according to the invention from the composition having a charged cerium concentration of at least 4 mol% relative to the entire charged rare earth elements. It is thus believed that by providing YAG:Ce phosphor with such a structure (crystallographic texture), YAG:Ce phosphor containing cerium in a high concentration of at least 4 mol% relative to the entire rare earth elements can be synthesized.

In the YAG:Ce phosphor of the invention, the size of cerium-rich nanocrystalline grains dispersed in the matrix phase varies with the composition thereof, especially the concentration of charged cerium relative to the entire rare earth elements, and other preparation conditions, and has a certain distribution. The size is typically in a range from 5 nm to 20 nm. If nanocrystalline grains are of too small size, the cerium concentration may not be so high. Also, if nanocrystalline grains are of too large size, it is difficult to maintain the crystalline phase in the YAG:Ce phosphor.

Preferably, the nanocrystalline grains having a high cerium concentration are distributed in the matrix phase as uniformly as possible.

The cerium concentration of the nanocrystalline grains (dispersed phase) and the matrix phase was measured by the energy-dispersive x-ray spectroscopy under transmission electron microscope (TEM-EDX), finding that the concentration of cerium contained in the nanocrystalline grains is higher than the concentration of cerium contained in the matrix phase. While the cerium concentration of the matrix phase is governed by the composition of the YAG:Ce phosphor, the nanocrystalline grains have a cerium concentration which is 1.01 to 3.00 times greater than that of the matrix phase as long as the composition is in the range of the invention. Differently stated, the cerium concentration of the nanocrystalline grains is 1 to 20% by weight higher than the cerium concentration of the matrix phase.

Although the nanocrystalline grain-forming mechanism is not well understood, the following is presumed. In the process of preparing a phosphor according to the invention, as an amorphous composition containing cerium in a large amount which is difficult to be introduced in essentially crystalline YAG:Ce alloys progressively crystallizes, cerium is expelled from the matrix phase everywhere throughout the crystallographic texture, and collects at micro-domains interspersed in the crystallographic texture. Consequently, nanocrystalline grains are formed as an alloy phase having a high cerium concentration dispersed throughout the crystallographic texture.

The YAG:Ce phosphor of the invention is represented by the compositional formula (1), for example.

YₐCe_{b}Al_{c}O_{d} (1)

Herein a and b are preferably in the range: 0.04 ≤ b/(a+b) ≤ 0.15, more preferably 0.04 ≤ b/(a+b) ≤ 0.10. Specifically, the cerium concentration is controlled to 4 to 15 mol%, preferably 4 to 10 mol% based on the sum of yttrium and cerium. If b/(a+b) is less than 0.04, then an equivalent x value on the xy chromaticity coordinates may be obtainable by the prior art YAG:Ce synthesis method without resorting to the inventive method and without adding gadolinium. If b/(a+b) exceeds 0.15, then it may be difficult for the YAG:Ce phosphor to maintain the garnet phase. It is noted that in formula (1), a+b = 3, 5.0 ≤ c s 5.5, and 12 ≤ d ≤ 12.75.

The chromaticity of emission color of the phosphor can be adjusted by changing the cerium concentration (concentration of charged cerium relative to charged yttrium). As the cerium concentration increases from 4 mol% to 15 mol%, the x value of chromaticity increases. When excited with 450 nm light, the phosphor produces emission color having a x value of at least 0.47, specifically 0.47 to 0.54 on the xy chromaticity coordinates. It is noted that the resulting phosphor is free of a phase other than the garnet phase, for example, an alumina phase.

Described below are temperature performance characteristics of the present YAG:Ce phosphors. As used herein, the term "phosphor temperature" refers to the temperature of an ambient atmosphere surrounding the phosphor. YAG:Ce phosphors were prepared according to the invention so that they might produce emission color with a x value of 0.47 to 0.54. These phosphors produced an emission spectrum when excited with 450 nm light. The peak intensity (P80) of emission spectrum at a phosphor temperature of 80°C was measured. Also the peak intensity (P25) of emission spectrum at a phosphor temperature of 25°C was measured. The peak intensity ratio (P80/P25) was at least 93%.

Also empirically, phosphors having an equivalent x value to the inventive YAG:Ce phosphor were prepared by the method of Patent Document 1 and by substituting gadolinium for part of yttrium. For the phosphor having any x value, the peak intensity ratio (P80/P25) was inferior to (or lower than) that of the inventive YAG:Ce phosphor having an equivalent x value.

In the future, LED devices will become of larger size and higher power. Then the LED device generates more heat whereby the device is at a high temperature, giving rise to a problem that phosphor performance is degraded. The problem is overcome by the present invention providing a YAG:Ce phosphor having improved fluorescent performance at high temperature over the YAG:Ce phosphor prepared by the prior art method of substituting gadolinium for part of yttrium.

It is now described how to prepare a YAG:Ce phosphor. According to the invention, the YAG:Ce phosphor is prepared by rapidly melting and cooling a phosphor composition raw material to form a YAG:Ce phosphor composition in amorphous state, and treating it for crystallization.

The YAG:Ce phosphor composition in amorphous state resulting from quenching/solidification can contain cerium in a higher concentration than the Gd-free YAG:Ce phosphor which is prepared by the solid-phase method. This is because the YAG:Ce phosphor composition in amorphous state has a distance between atoms constituting the composition which is wider than in the crystal of the same composition. Then the composition containing much cerium ions having a greater ionic radius than yttrium ions does not possess the function to expel cerium ions out of the composition. The inventors have empirically confirmed that the YAG:Ce phosphor composition in amorphous state can contain cerium in a proportion of up to 15 mol% to substitute for part of yttrium.

The phosphor raw material is obtained by mixing yttrium, aluminum and cerium compounds which include oxides, hydroxides, organic acid salts, and mineral acid salts. Of these, oxides and hydroxides are preferable for cost and ease of handling. The raw material is in particulate form which preferably has as small a particle size as possible from the standpoint of obtaining phosphor particles of uniform composition. The compounds as the raw material have an average particle size of not greater than 1 µm. Yttrium, cerium and aluminum compounds are combined so as to provide a predetermined molar ratio of Y, Al and Ce to the phosphor composition. For example, the compounds are combined such that a cerium concentration is 4 to 15 mol% based on the entire rare earth elements, and a molar ratio of aluminum to the sum of yttrium and cerium is 5/3 to 5.5/3.

The raw material as mixed may be granulated into particles having a certain particle size which is dependent on the particle size of the final phosphor. For example, the raw material is granulated into particles having an average particle size of 5 to 100 µm, preferably 10 to 65 µm. Granulation techniques include tumbling granulation, spray drying, and dry pulverization/classification. A proper technique may be selected as long as the final phosphor of the desired particle size is available. A dispersant may be added for the purpose of improving the mixed state of the raw material prior to granulation. Further, a binder may be added for the purpose of facilitating binding of particles during granulation. In this case, the granulated powder is fired to remove the binder.

The phosphor raw material (or granulated powder) is melted in a high-temperature atmosphere and rapidly cooled, yielding the YAG:Ce phosphor composition in amorphous state. More specifically, the particles as granulated to an average particle size of 5 to 100 µm are melted in a high-temperature plasma. The melting temperature of the phosphor raw material may be at least 2,500°C, preferably at least 4,000°C, and more preferably at least 10,000°C. The cooling temperature may be around room temperature, and the atmosphere is preferably air or nitrogen atmosphere.

Immediately after exiting the plasma, the molten particles are rapidly cooled into spherical particles. The size of the outgoing spherical particles substantially corresponds to the size of the granulated particles. That is, spherical particles having an average particle size of 5 to 100 µm are recovered. The spherical particles thus recovered are less crystalline or amorphous (i.e., YAG:Ce phosphor composition in amorphous state).

The YAG:Ce phosphor composition in amorphous state is then heat treated, yielding a crystalline YAG:Ce phosphor. The temperature of heat treatment should preferably be 900 to 1,700°C, more preferably 1,200 to 1,650°C, and even more preferably 1,400 to 1,600°C. Temperatures below 900°C are insufficient to promote crystal growth in particles, resulting in a phosphor having a low emission efficiency. Temperatures above 1,700°C may cause particles to be fused together. The heat treatment atmosphere is preferably a reducing atmosphere, for example, an atmosphere of argon or nitrogen in admixture with hydrogen.

Prior to the heat treatment in a high-temperature atmosphere, cerium is distributed substantially uniform in the particle interior. After conversion of the particles to a highly crystalline YAG:Ce phosphor by the heat treatment in a high-temperature atmosphere, substantially the entirety of cerium is retained within the phosphor particles. Through the heat treatment step, nanocrystalline grains are formed in the matrix phase of YAG:Ce phosphor particles. Specifically, nanocrystalline grains are dispersed in the matrix phase of the YAG:Ce phosphor texture.

On X-ray diffraction (XRD) analysis, the phosphor thus obtained is identified to be yttrium-cerium-aluminum garnet.

The YAG:Ce phosphor of the invention is suited as a phosphor for converting the wavelength of light from a light-emitting element to construct a light-emitting device or light-emitting diode, especially as a phosphor to construct warm-color white LED. The particulate YAG:Ce phosphor of the invention is advantageously used in a light-emitting diode, and an illuminating device or backlight device may be fabricated therefrom.

A further embodiment of the invention is a light-emitting device comprising the YAG:Ce phosphor defined as above and a light-emitting element for emitting light having a wavelength of 400 to 470 nm. They are coupled such that at least part of the light from the light-emitting element is wavelength converted (e.g., converted to white light) by the YAG:Ce phosphor. The particulate phosphor of the invention is suited for converting the wavelength of light from a light-emitting element to construct a light-emitting diode. The particulate phosphor of the invention is advantageously used in a light-emitting diode, and an illuminating device or backlight device may be fabricated therefrom. Using the phosphor for wavelength conversion of part of light from blue LED, a warm-color white LED device which is not achievable with the prior art YAG:Ce garnet phosphor can be manufactured.

### EXAMPLE

Examples are given below by way of illustration and not by way of limitation.

### Example 1

A yttrium oxide powder having a purity of 99.9 wt% and an average particle size of 1.0 µm, an aluminum oxide powder having a purity of 99.0 wt% and an average particle size of 0.5 µm, and a cerium oxide powder having a purity of 99.9 wt% and an average particle size of 0.2 µm were mixed to form 1,000 g of a powder mixture having a molar ratio of Y/Al/Ce = 2.88/5.00/0.12. The powder mixture was combined with 1,500 g of deionized water, 10 g of ammonium polyacrylate, and 2 g of carboxymethyl cellulose, and milled in a ball mill for 6 hours. Using a two-fluid nozzle, the resulting slurry was granulated into particles having an average particle size of 15 µm. The particles were heat treated in air at 1,000°C for 2 hours to burn out the organic matter.

An RF induction thermal plasma system was used. The particles were passed through the argon plasma where they were melted and then solidified, obtaining spherical particles. On qualitative analysis by X-ray diffractometer (XRD), the spherical particles were found to be amorphous composite.

The spherical particles were heat treated in 1 vol% hydrogen-containing argon gas at 1,350°C for 5 hours, yielding phosphor particles.

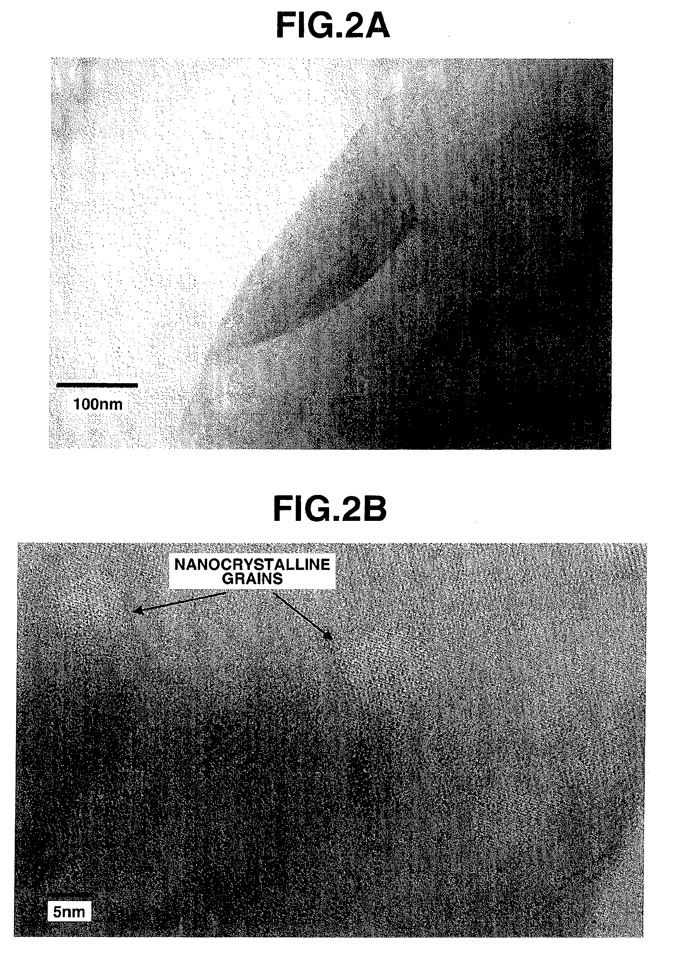

FIG. 2 is a micrograph showing the crystallographic texture of the phosphor particles observed under a transmission electron microscope Model H9000NAR (Hitachi Ltd.). The crystallographic texture of phosphor particles is a collection of crystalline grains (see FIG. 2a). In the crystallographic texture (matrix phase) of phosphor particles, a distribution of nanocrystalline grains with a size of 5 to 10 nm whose crystal arrangement is different from the surrounding (matrix phase) was observed.

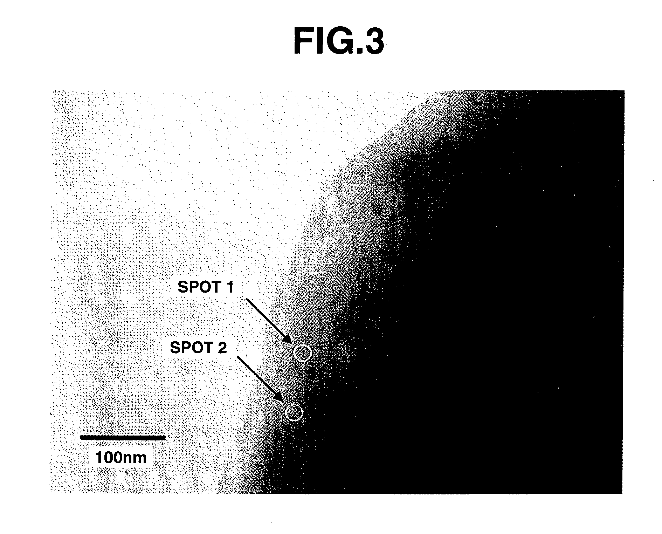

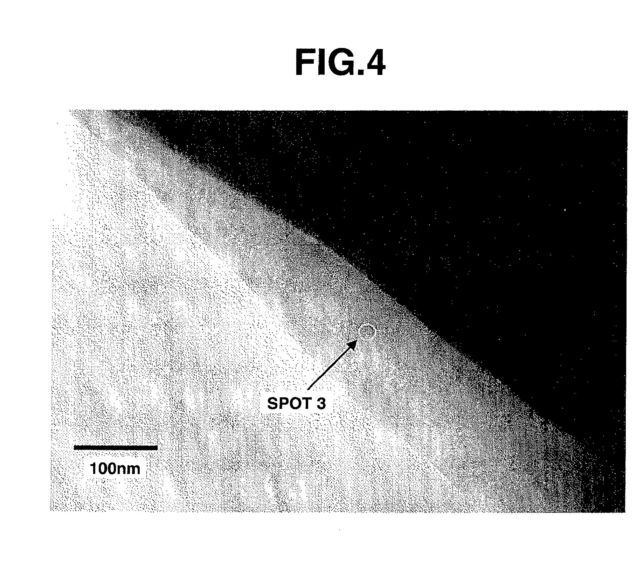

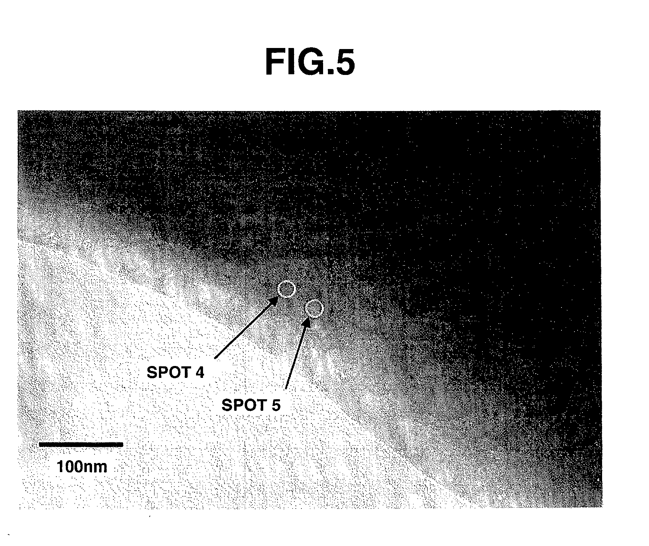

With respect to this crystallographic texture, the cerium content was measured by EDX at a spot having a beam diameter of about 10 nm in the TEM images from three different fields of view as shown in FIGS. 3 to 5. As a result, the cerium content was 6.3 wt% at spot 1 (matrix portion) and 8.1 wt% at spot 2 (nanocrystalline portion) in FIG. 3; 9.3 wt% at spot 3 (nanocrystalline portion) in FIG. 4; 5.8 wt% at spot 4 (matrix portion) and 12.2 wt% at spot 5 (nanocrystalline portion) in FIG. 5.

When excited with 450 nm light (i.e., light having a peak at wavelength 450 nm), the phosphor particles emitted light whose chromaticity had x = 0.474 on the xy chromaticity coordinates as measured by chromaticity measuring system Model QE1100 (Otsuka Electronics Co., Ltd.).

Also, the phosphor was kept at a temperature of 25°C or 80°C by heating. The emission spectrum of the phosphor at the temperature of 25°C or 80°C upon excitation with 450 nm light was measured by a spectrometer Model FP6500 (JASCO Corp.). The peak intensities of these emission spectra were compared. Provided that the peak intensity at the phosphor temperature of 25°C was 100, the peak intensity at the phosphor temperature of 80°C was 97.5.

### Example 2

A yttrium oxide powder having a purity of 99.9 wt% and an average particle size of 1.0 µm, an aluminum oxide powder having a purity of 99.0 wt% and an average particle size of 0.5 µm, and a cerium oxide powder having a purity of 99.9 wt% and an average particle size of 0.2 µm were mixed to form 1,000 g of a powder mixture having a molar ratio of Y/Al/Ce = 2.79/5.50/0.21. The powder mixture was combined with 1,500 g of deionized water, 10 g of ammonium polyacrylate, and 2 g of carboxymethyl cellulose, and milled in a ball mill for 6 hours. Using a spray drier, the resulting slurry was granulated into particles having an average particle size of 20 µm. The particles were heat treated in air at 1,500°C for 2 hours to burn out the organic matter.

An RF induction thermal plasma system was used. The particles were passed through the argon plasma where they were melted and then solidified, obtaining spherical particles. On qualitative analysis by XRD, the spherical particles were found to be amorphous composite.

The spherical particles were heat treated in 1 vol% hydrogen-containing argon gas at 1,500°C for 4 hours, yielding phosphor particles.

The crystallographic texture of these phosphor particles was observed under TEM. Nanocrystalline grains dispersed in the crystallographic texture (matrix phase) were seen. The nanocrystalline grains had a size of 5 to 10 nm.

When excited with 450 nm light, the phosphor particles emitted light whose chromaticity had x = 0.501 on the xy chromaticity coordinates as measured by chromaticity measuring system Model QE1100 (Otsuka Electronics Co., Ltd.).

Also, the phosphor was kept at a temperature of 25°C or 80°C by heating. The emission spectrum of the phosphor at the temperature of 25°C or 80°C upon excitation with 450 nm light was measured as in Example 1. The peak intensities of these emission spectra were compared. Provided that the peak intensity at the phosphor temperature of 25°C was 100, the peak intensity at the phosphor temperature of 80°C was 93.7.

### Example 3

99.9 wt% pure yttrium nitrate, 99.0 wt% pure aluminum nitrate, and 99.9 wt% pure cerium nitrate were mixed in a molar ratio of Y/Al/Ce = 2.85/5.30/0.15 and dissolved in water to form 10 L of a 0.25 mol/L solution. To the solution, 20 L of 0.5 mol/L aqueous ammonia was slowly added, obtaining about 2 kg of hydroxide mixture.

The hydroxide mixture was combined with 5,000 g of deionized water, 30 g of ammonium polyacrylate, and 50 g of carboxymethyl cellulose, and milled in a ball mill for 6 hours. Using a spray drier, the resulting slurry was granulated into particles having an average particle size of 20 µm. The particles were heat treated in air at 1,500°C for 2 hours to burn out the organic matter.

An RF induction thermal plasma system was used. The particles were passed through the argon plasma where they were melted and then solidified, obtaining spherical particles. On qualitative analysis by XRD, the spherical particles were found to be amorphous composite.

The spherical particles were heat treated in 1 vol% hydrogen-containing argon gas at 1,500°C for 4 hours, yielding phosphor particles.

The crystallographic texture of these phosphor particles was observed under TEM. Nanocrystalline grains dispersed in the crystallographic texture (matrix phase) were seen. The nanocrystalline grains had a size of 5 to 10 nm.

When excited with 450 nm light, the phosphor particles emitted light whose chromaticity had x = 0.485 on the xy chromaticity coordinates as measured by chromaticity measuring system Model QE1100 (Otsuka Electronics Co., Ltd.).

Also, the phosphor was kept at a temperature of 25°C or 80°C by heating. The emission spectrum of the phosphor at the temperature of 25°C or 80°C upon excitation with 450 nm light was measured as in Example 1. The peak intensities of these emission spectra were compared. Provided that the peak intensity at the phosphor temperature of 25°C was 100, the peak intensity at the phosphor temperature of 80°C was 96.5.

### Comparative Example 1

A yttrium oxide powder having a purity of 99.9 wt% and an average particle size of 1.0 µm, an aluminum oxide powder having a purity of 99.0 wt% and an average particle size of 3.0 µm, and a cerium oxide powder having a purity of 99.9 wt% and an average particle size of 0.2 µm were mixed to form 1,000 g of a powder mixture having a molar ratio of Y/Al/Ce = 2.85/5.00/0.15. To the powder mixture was added 200 g of barium fluoride as flux. After thorough mixing, the mixture was placed in an alumina crucible and heat treated in an atmosphere of 2 vol% hydrogen and 98 vol% argon at 1,400°C for 4 hours. The fired product was washed with water, separated and dried, obtaining phosphor particles.

The phosphor particles were observed under an electron microscope. The particles were polyhedral, with crystal faces perceived.

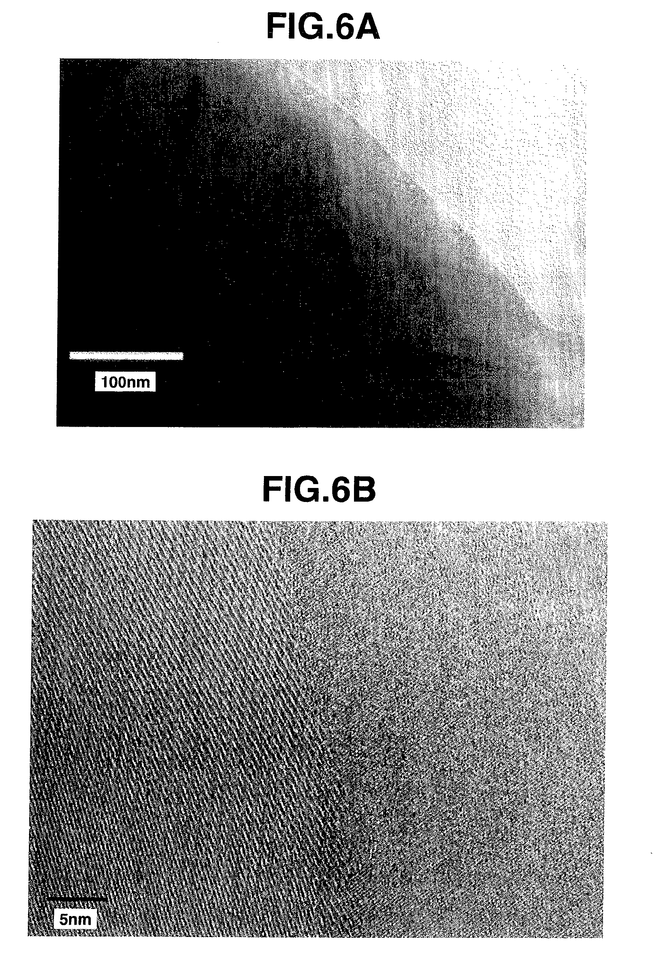

The crystallographic texture of the phosphor particles was observed under TEM. As seen from FIG. 6, no nanocrystalline grains were observed in the crystallographic texture.

When excited with 450 nm light, the phosphor particles emitted light whose chromaticity had x = 0.460 on the xy chromaticity coordinates. The x value was low although the raw material had the same composition as in Example 1.

### Comparative Example 2

A yttrium oxide powder having a purity of 99.9 wt% and an average particle size of 1.0 µm, a gadolinium oxide powder having a purity of 99.9 wt% and an average particle size of 1.0 µm, an aluminum oxide powder having a purity of 99.0 wt% and an average particle size of 3.0 µm, and a cerium oxide powder having a purity of 99.9 wt% and an average particle size of 0.2 µm were mixed to form 1,000 g of a powder mixture having a molar ratio of Y/Gd/Al/Ce = 2.058/0.882/5.00/0.06. To the powder mixture was added 200 g of barium fluoride as flux. After thorough mixing, the mixture was placed in an alumina crucible and heat treated in an atmosphere of 2 vol% hydrogen and 98 vol% argon at 1,400°C for 4 hours. The fired product was washed with water, separated and dried, obtaining phosphor particles.

The phosphor particles were observed under an electron microscope. The particles were polyhedral, with crystal faces perceived.

The crystallographic texture of the phosphor particles was observed under TEM. No nanocrystalline grains were observed in the crystallographic texture.

When excited with 450 nm light, the phosphor particles emitted light whose chromaticity had x = 0.477 on the xy chromaticity coordinates, indicating a chromaticity approximately equal to Example 1.

Also, the phosphor was kept at a temperature of 25°C or 80°C by heating. The emission spectrum of the phosphor at the temperature of 25°C or 80°C upon excitation with 450 nm light was measured as in Example 1. The peak intensities of these emission spectra were compared. Provided that the peak intensity at the phosphor temperature of 25°C was 100, the peak intensity at the phosphor temperature of 80°C was 91.4.

### Comparative Example 3

A yttrium oxide powder having a purity of 99.9 wt% and an average particle size of 1.0 µm, a gadolinium oxide powder having a purity of 99.9 wt% and an average particle size of 1.0 µm, an aluminum oxide powder having a purity of 99.0 wt% and an average particle size of 3.0 µm, and a cerium oxide powder having a purity of 99.9 wt% and an average particle size of 0.2 µm were mixed to form 1,000 g of a powder mixture having a molar ratio of Y/Gd/Al/Ce = 2.058/0.882/5.00/0.12. To the powder mixture was added 200 g of barium fluoride as flux. After thorough mixing, the mixture was placed in an alumina crucible and heat treated in an atmosphere of 2 vol% hydrogen and 98 vol% argon at 1,400°C for 4 hours. The fired product was washed with water, separated and dried, obtaining phosphor particles.

The phosphor particles were observed under an electron microscope. The particles were polyhedral, with crystal faces perceived.

The crystallographic texture of the phosphor particles was observed under TEM. No nanocrystalline grains were observed in the crystallographic texture.

When excited with 450 nm light, the phosphor particles emitted light whose chromaticity had x = 0.500 on the xy chromaticity coordinates, indicating a chromaticity approximately equal to Example 2.

Also, the phosphor was kept at a temperature of 25°C or 80°C by heating. The emission spectrum of the phosphor at the temperature of 25°C or 80°C upon excitation with 450 nm light was measured as in Example 1. The peak intensities of these emission spectra were compared. Provided that the peak intensity at the phosphor temperature of 25°C was 100, the peak intensity at the phosphor temperature of 80°C was 90.3.

### Notes

In respect of numerical ranges disclosed in the present description it will of course be understood that in the normal way the technical criterion for the upper limit is different from the technical criterion for the lower limit, i.e. the upper and lower limits are intrinsically distinct proposals.

For the avoidance of doubt it is confirmed that in the general description above, in the usual way the proposal of general preferences and options in respect of different features of the phosphor, device comprising it and method of making it constitutes the proposal of general combinations of those general preferences and options for the different features, insofar as they are combinable and compatible and are put forward in the same context.

## Claims

1. An yttrium-cerium-aluminium garnet phosphor having a crystallographic texture wherein the crystallographic texture is based on a matrix phase, and nanocrystalline grains having a grain size of 5 to 20 nm and containing cerium in a higher concentration than the cerium concentration of the matrix phase are dispersed in the crystallographic texture.

2. The phosphor of claim 1 which produces emission color having a x value of 0.47 to 0.54 on the xy chromaticity coordinates when excited with 450 nm light.

3. The phosphor of claim 1 or 2 wherein cerium is present in a concentration of 4 mol% to 15 mol% based on the sum of yttrium and cerium.

4. The phosphor of any one of claims 1 to 3 wherein the cerium concentration of the nanocrystalline grains is 1 to 20% by weight higher than the cerium concentration of the matrix phase.

5. The phosphor of any one of claims 1 to 4 which produces an emission spectrum when excited with 450 nm light, wherein the peak intensity of emission spectrum at a phosphor temperature of 80°C is at least 93% of the peak intensity of emission spectrum at a phosphor temperature of 25°C.

6. A light-emitting device comprising a light-emitting element for emitting light having a wavelength of 400 to 470 nm and a phosphor of any one of claims 1 to 5 for converting the wavelength of at least part of light from the light-emitting element.

7. A method of making a phosphor of any one of claims 1 to 5, in which a raw material mixture is melted and cooled to form a YAG:Ce phosphor composition in an amorphous state, and this composition is crystallized to form the phosphor having said crystallographic texture and nanocrystalline grains.

## Patentansprüche

1. Yttrium-Cer-Aluminiumgranat-Luminophor mit kristallographischer Struktur, worin die kristallographische Struktur auf einer Matrixphase beruht und nanokristalline Körnchen mit einer Körnchengröße von 5 bis 20 nm, die Cer in einer Konzentration enthalten, die höher ist als die Cerkonzentration der Matrixphase, in der kristallographischen Struktur verteilt sind.

2. Luminophor nach Anspruch 1, der bei Anregung mit 450-nm-Licht eine Emissionsfarbe mit einem x-Wert von 0,47 bis 0,54 auf den x-y-Farbwertkoordinaten erzeugt.

3. Luminophor nach Anspruch 1 oder 2, worin Cer in einer Konzentration von 4 Mol-% bis 15 Mol-%, bezogen auf die Summe aus Yttrium und Cer, vorliegt.

4. Luminophor nach einem der Ansprüche 1 bis 3, worin die Cerkonzentration der nanokristallinen Körnchen um 1 bis 20 Gew.-% höher ist als die Cerkonzentration der Matrixphase.

5. Luminophor nach einem der Ansprüche 1 bis 4, der bei Anregung mit 450-nm-Licht ein Emissionsspektrum erzeugt, worin die Peak-Intensität des Emissionsspektrums bei einer Luminophortemperatur von 80 °C zumindest 93 % der Peak-Intensität des Emissionsspektrums bei einer Luminophortemperatur von 25 °C beträgt.

6. Lichtemittierende Vorrichtung, die ein lichtemittierendes Element zur Emission von Licht mit einer Wellenlänge von 400 bis 470 nm und einen Luminophor nach einem der Ansprüche 1 bis 5 zur Umwandlung der Wellenlänge zumindest eines Teils des Lichts aus dem lichtemittierenden Element umfasst.

7. Verfahren zur Herstellung eines Luminophors nach einem der Ansprüche 1 bis 5, worin ein Rohmaterialgemisch geschmolzen und gekühlt wird, um eine YAG:Ce-Luminophorzusammensetzung in amorphem Zustand zu bilden, und diese Zusammensetzung kristallisiert wird, um einen Luminophor mit der kristallographischen Struktur und den nanokristallinen Körnchen zu bilden.

## Revendications

1. Luminophore grenat à base d'yttrium-cérium-aluminium ayant une texture cristallographique, dans lequel la texture cristallographique est basée sur une phase de matrice, et des grains nanocristallins ayant une granulométrie de 5 à 20 nm et contenant du cérium à une concentration supérieure à la concentration de cérium dans la phase de matrice sont dispersés dans la texture cristallographique.

2. Luminophore selon la revendication 1, qui produit une couleur d'émission ayant une valeur x de 0,47 à 0,54 sur les coordonnées de chromaticité xy lorsqu'il est excité avec une lumière à 450 nm.

3. Luminophore selon la revendication 1 ou 2, dans lequel le cérium est présent à une concentration de 4 % en moles à 15 % en moles par rapport à la somme de l'yttrium et du cérium.

4. Luminophore selon l'une quelconque des revendications 1 à 3, dans lequel la concentration de cérium dans les grains nanocristallins est supérieure de 1 à 20 % en poids à la concentration de cérium dans la phase de matrice.

5. Luminophore selon l'une quelconque des revendications 1 à 4, qui produit un spectre d'émission quand il est excité avec une lumière à 450 nm, dans lequel l'intensité de pic du spectre d'émission à une température du luminophore de 80°C est d'au moins 93 % de l'intensité de pic du spectre d'émission à une température du luminophore de 25°C.

6. Dispositif luminescent comprenant un élément luminescent pour émettre une lumière ayant une longueur d'onde de 400 à 470 nm et un luminophore selon l'une quelconque des revendications 1 à 5 pour convertir la longueur d'onde d'au moins une partie de la lumière provenant de l'élément luminescent.

7. Procédé pour produire un luminophore selon l'une quelconque des revendications 1 à 5, dans lequel un mélange de matières premières est fondu et refroidi pour former une composition de luminophore YAG:Ce dans un état amorphe, et cette composition est cristallisée pour former le luminophore ayant ladite texture cristallographique et des grains nanocristallins.
